# EUROPEAN PATENT APPLICATION

(11) **EP 4 546 967 A1**
(43) Date of publication of application: **30.04.2025**
(21) Application number: 23859016.0
(22) Date of filing: 31.07.2023
(51) Int. Cl.: H05K 7/20, H02M 1/00, H02M 1/32, H02S 40/30

(54) **POWER DEVICE AND PHOTOVOLTAIC SYSTEM**

(30) Priority: 31.08.2022 CN 202211056306
(71) Applicant: Huawei Digital Power Technologies Co., Ltd., Shenzhen, Guangdong 518043 (CN)
(72) Inventor: SUN, Faming, Shenzhen, Guangdong 518043 (CN); MENG, Hao, Shenzhen, Guangdong 518043 (CN); HUI, Xiaowei, Shenzhen, Guangdong 518043 (CN)
(74) Representative: Maiwald GmbH
(86) International application number: PCT/CN2023/110164
(87) International publication number: WO 2024/045981

(57) **Abstract**

This application provides a power device and a photovoltaic system, to improve heat dissipation performance of the power device, thereby improving use reliability of the power device. The power device includes a housing and a heat dissipation apparatus, where a partition board is disposed in the housing, the partition board divides the housing into a first cavity and a second cavity, and the partition board is provided with a first opening and a second opening that communicate the first cavity with the second cavity. A to-be-heat-dissipated component is disposed in the first cavity. The second cavity is provided with an air inlet and an air outlet, and the air inlet and the air outlet are provided opposite to each other in a first direction. The heat dissipation apparatus includes a first fin disposed in the second cavity, where a channel is provided in the first fin, the channel runs through the first fin in a second direction, and two ends of the channel are respectively in communication with the first opening and the second opening; and a minimum included angle between the second direction and the first direction is greater than 0° and less than or equal to 90°.

## Description

### CROSS-REFERENCE TO RELATED APPLICATIONS

This application claims priority to Chinese Patent Application No. 202211056306.X, filed with the China National Intellectual Property Administration on August 31, 2022, and entitled "POWER DEVICE AND PHOTOVOLTAIC SYSTEM", which is incorporated herein by reference in its entirety.

### TECHNICAL FIELD

This application relates to the field of heat dissipation technologies, and in particular, to a power device and a photovoltaic system.

### BACKGROUND

As power of an inverter increases, heat generated by structures such as a board, an on-board component, and a cable inside a chassis of the inverter also increases. Heat-sensitive components such as electrolytic capacitors are placed inside the chassis. Therefore, a temperature rise inside the chassis directly determines performance of these components. Currently, the chassis of the inverter mainly relies on walls of the chassis for natural heat dissipation to the outside. However, a heat dissipation capability of this heat dissipation manner is limited, and consequently, effective cooling cannot be implemented inside the case. As a result, a service life and reliability of the components inside the chassis are affected, and then an overall service life of the inverter is affected.

### SUMMARY

This application provides a power device and a photovoltaic system, to improve heat dissipation performance of the power device, thereby improving use reliability of the power device.

According to a first aspect, this application provides a power device. The power device may include a housing and a heat dissipation apparatus. A partition board is disposed in the housing, and the partition board may divide the housing into a first cavity and a second cavity. The partition board is provided with a first opening and a second opening, and the first opening and the second opening separately communicate the first cavity with the second cavity. A to-be-heat-dissipated component is disposed in the first cavity. The second cavity is provided with an air inlet and an air outlet, and the air inlet and the air outlet may be provided opposite to each other in a first direction. The heat dissipation apparatus may include a first fin disposed in the second cavity, where a surface of the first fin is disposed facing the partition board, a channel is provided in the first fin, the channel may run through the first fin in a second direction, and two ends of the channel may be respectively in communication with the first opening and the second opening. A minimum included angle between the first direction and the second direction is greater than 0° and less than or equal to 90°.

In the foregoing solution, an air circulation loop may be formed between an internal part of the first cavity and the channel of the first fin, so that air in the first cavity can implement heat exchange with air flowing through the surface of the first fin in a circular flow process. In this way, heat dissipation effect inside the first cavity can be effectively improved, then a failure risk of the components inside the first cavity can be reduced, and use reliability of the power device can be improved.

For example, the first direction may be a height direction of the power device, and the second direction may be a width direction of the power device.

In some possible implementation solutions, there may be a plurality of first fins, and an air duct extending in the first direction may be formed between the adjacent first fins. This helps improve efficiency of heat exchange between the first fins and air entering the second cavity, and then can improve heat dissipation effect inside the first cavity.

In some possible implementation solutions, the heat dissipation apparatus may further include a first guide member and a second guide member that are disposed in the second cavity, where one end of the first guide member is in communication with the first opening, the other end is in communication with one end of the channel of the first fin, one end of the second guide member is in communication with the second opening, and the other end is in communication with the other end of the channel of the first fin. The first guide member and the second guide member may further play a role of supporting and fastening the first fin in addition to communicating the channel of the first fin with the first cavity, thereby improving structural stability of the heat dissipation apparatus.

In some possible implementation solutions, the to-be-heat-dissipated component in the first cavity may include a first to-be-heat-dissipated component, and the first to-be-heat-dissipated component is disposed close to the partition board. The heat dissipation apparatus may further include a plurality of second fins and a base board that are disposed in the second housing. The base board is disposed on the partition board, and the base board is in heat-conductive contact with the first to-be-heat-dissipated component. The second fins are disposed on a side that is of the base board and that is away from the partition board, the second fins extend in a direction away from the partition board and an air duct extending in the first direction may be formed between two adjacent second fins. Heat generated when the first to-be-heat-dissipated component works may be transferred to the base board, then transferred to the second fins via the base board, and further transferred by the second fins to air flowing through surfaces of the second fins. In this way, heat dissipation of the first to-be-heat-dissipated component can be implemented.

For example, the first to-be-heat-dissipated component may be specifically a power component.

In some possible implementation solutions, the first fins may be disposed on a side that is of a free end of each of the plurality of second fins and that is away from the base board, to improve structural compactness of the heat dissipation apparatus.

In some other possible implementation solutions, the plurality of second fins may be divided into a first portion and a second portion. In the direction away from the base board, a height of the second fins in the first portion is less than a height of the second fins in the second portion. In this case, the first fins may be disposed on a side that is of a free end of each second fin in the first portion and that is away from the base board. This design can also improve compactness of the heat dissipation apparatus.

In some possible implementations, a projection of an outer profile of the base board on a surface of the partition board may be located between the first opening and the second opening. Alternatively, a region enclosed by a projection of an outer profile of the base board on a surface of the partition board may cover the first opening and the second opening. In this case, the base board is provided with a first avoidance hole and a second avoidance hole respectively at positions corresponding to the first opening and the second opening, an end of the first guide member may pass through the first avoidance hole to communicate with the first opening, and the second guide member may pass through the second avoidance hole to communicate with the second opening. This design can increase an area of the base board, thereby helping improve heat dissipation effect of the first to-be-heat-dissipated component.

In some possible implementation solutions, the partition board may be provided with a hole at a position corresponding to the first to-be-heat-dissipated component, and the first to-be-heat-dissipated component may extend into the hole and be in heat-conductive contact with the base board. In this way, efficiency of heat exchange between the first to-be-heat-dissipated component and the heat dissipation apparatus can be improved, thereby helping improve the heat dissipation effect of the first to-be-heat-dissipated component.

In some possible implementation solutions, the heat dissipation apparatus may further include a first fan disposed in the second cavity, where an air intake side of the first fan is disposed facing the air inlet, and an air exhaust side of the first fan is disposed facing the air outlet. In this way, an air circulation rate in the second cavity can be improved, and then heat dissipation effect of the heat dissipation apparatus can be improved.

In some possible implementation solutions, the to-be-heat-dissipated component in the first cavity may further include a second to-be-heat-dissipated component and a third to-be-heat-dissipated component. The heat dissipation apparatus further includes a second fan disposed in the first cavity. The second to-be-heat-dissipated component may be disposed between the first opening and an air intake side of the second fan. The third to-be-heat-dissipated component may be disposed between an air exhaust side of the second fan and the second opening, and the third to-be-heat-dissipated component is located on a side that is of the first to-be-heat-dissipated component and that is away from the partition board. After the air cooled through heat exchange in the first fins enters the first cavity from the first opening, the low-temperature air may first pass through the second to-be-heat-dissipated component, and then be blown to the third to-be-heat-dissipated component by the second fan after heat exchange with the second to-be-heat-dissipated component, to further perform heat exchange with the third to-be-heat-dissipated component, and then flow to the first fins from the second opening, to complete a cycle, thereby implementing heat dissipation of each to-be-heat-dissipated component in the first cavity.

In some possible implementation solutions, the heat dissipation apparatus may further include a third guide member disposed in the first cavity. The third guide member is in communication with the first opening, and the third guide member is provided with a first air vent at a position facing the third to-be-heat-dissipated component. The second to-be-heat-dissipated component is disposed in the third guide member. The second fan is disposed at the first air vent, and the air intake side of the second fan is disposed opposite to the first air vent. The third guide member is disposed, so that the second to-be-heat-dissipated component may be limited to relatively sealed space, and a risk that air on the air exhaust side of the second fan flows back to a place near the second to-be-heat-dissipated component is reduced. This helps further improve heat dissipation effect of the second to-be-heat-dissipated component.

In some possible implementation solutions, the heat dissipation apparatus may further include a third fan and a fourth guide member that are disposed in the first cavity. The fourth guide member is in communication with the second opening, and the fourth guide member is provided with a second air vent at a position facing the third to-be-heat-dissipated component. The third fan may be disposed at the second air vent, an air intake side of the third fan is disposed facing the third to-be-heat-dissipated component, and an air exhaust side of the third fan is disposed opposite to the second air vent. The third fan and the fourth guide member are disposed, so that a risk that air flows back to a place near the second to-be-heat-dissipated component can be further reduced. This helps improve use reliability of the second to-be-heat-dissipated component.

For example, the second to-be-heat-dissipated component may be specifically an electrolytic capacitor board, and the third to-be-heat-dissipated component may be specifically an output board.

In some possible implementation solutions, a fourth to-be-heat-dissipated component may be further disposed in the second cavity, and the fourth to-be-heat-dissipated component may be disposed on a side that is of the first fin and that faces the air outlet. For example, the fourth to-be-heat-dissipated component may be a magnetic component. Because a protection requirement of the magnetic component is low, specific heat dissipation effect of the magnetic component may still be achieved when the magnetic component is disposed in a downstream of a heat dissipation path, and a normal operation of the magnetic component is ensured.

According to a second aspect, this application further provides a photovoltaic system. The photovoltaic system may include a panel and the power device in any possible implementation solution of the first aspect. The panel may be configured to convert solar energy into electric energy. The power device may be configured to perform power conversion on a current from the panel, or perform power conversion on a voltage from the panel, to enable output power of the photovoltaic system to match power of an external electric device. Because heat dissipation performance of the power device is good, reliability of the photovoltaic system is also improved.

### BRIEF DESCRIPTION OF DRAWINGS

FIG. 1 is a side sectional view of a power device according to an embodiment of this application;
FIG. 2 is a sectional view of the power device shown in FIG. 1 in a top-view state;
FIG. 3 is a diagram of a partial structure of a heat dissipation apparatus shown in FIG. 1;
FIG. 4 is a side sectional view of another power device according to an embodiment of this application;
FIG. 5 is a sectional view of the power device shown in FIG. 4 in a top-view state;
FIG. 6 is a sectional view of a first cavity of the power device shown in FIG. 4 in a direction perpendicular to a third direction;
FIG. 7 is a sectional view of another power device in a top-view state according to an embodiment of this application;
FIG. 8 is a sectional view of a first cavity of the power device shown in FIG. 7 in a direction perpendicular to a third direction;
FIG. 9 is a sectional view of another power device in a top-view state according to an embodiment of this application;
FIG. 10 is a sectional view of a first cavity of the power device shown in FIG. 9 in a direction perpendicular to a third direction;
FIG. 11 is a sectional view of another power device in a top-view state according to an embodiment of this application;
FIG. 12 is a sectional view of a first cavity of the power device shown in FIG. 11 in a direction perpendicular to a third direction;
FIG. 13 is a side sectional view of another power device according to an embodiment of this application;
FIG. 14 is a sectional view of the power device shown in FIG. 13 in a top-view state;
FIG. 15 is a diagram of a partial structure of a heat dissipation apparatus shown in FIG. 14;
FIG. 16 is a side sectional view of another power device according to an embodiment of this application;
FIG. 17 is a sectional view of the power device shown in FIG. 16 in a top-view state;
FIG. 18 is a diagram of a partial structure of a heat dissipation apparatus shown in FIG. 16;
FIG. 19 is a side sectional view of another power device according to an embodiment of this application;
FIG. 20 is a sectional view of the power device shown in FIG. 19 in a top-view state;
FIG. 21 is a diagram of a partial structure of a heat dissipation apparatus shown in FIG. 19;
FIG. 22 is a side sectional view of another power device according to an embodiment of this application;
FIG. 23 is a sectional view of the power device shown in FIG. 22 in a top-view state; and
FIG. 24 is a diagram of a partial structure of a heat dissipation apparatus shown in FIG. 22.

### Reference numerals:

100: power device; 110: housing; 111: partition board; 1111: first opening; 1112: second opening; 1101: first side wall;
1102: second side wall; 1103: third side wall; 1104: fourth side wall; 1105: fifth side wall; 1106: sixth side wall;
112: first cavity; 113: second cavity; 1131: air inlet; 1132: air outlet; 120: heat dissipation apparatus;
121: first fin; 122: first fan; 123: first guide member; 124: second guide member; 125: base board;
1251: first avoidance hole; 1252: second avoidance hole; 126, 1261, 1262: second fin; 127: second fan;
128: third guide member; 129: third fan; 1210: fourth guide member; 1211: mounting board;
1212: first support member; 1213: second support member; 131: first to-be-heat-dissipated component and power component; 132: power board;
133: second to-be-heat-dissipated component and electrolytic capacitor board; 134: third to-be-heat-dissipated component and output board; 135: electrolytic capacitor;
136: fourth to-be-heat-dissipated component.

### DESCRIPTION OF EMBODIMENTS

To make objectives, technical solutions, and advantages of this application clearer, the following further describes this application in detail with reference to the accompanying drawings. However, example implementations may be implemented in a plurality of forms, and should not be construed as being limited to implementations described herein. Identical reference numerals in the accompanying drawings denote identical or similar structures. Therefore, repeated descriptions thereof are omitted. Expressions of positions and directions in embodiments of this application are described by using the accompanying drawings as an example. However, changes may also be made as required, and all the changes fall within the protection scope of this application. The accompanying drawings in embodiments of this application are merely used to illustrate relative position relationships and do not represent an actual scale.

It should be noted that specific details are set forth in the following descriptions to provide a thorough understanding of this application. However, this application can be implemented in numerous other manners different from those described herein, and a person skilled in the art can make similar inferences without departing from the connotation of this application. Therefore, this application is not limited to the specific implementations disclosed below.

A photovoltaic system is a power generation system that uses photovoltaic effect of a semiconductor material to convert solar energy into electric energy. The photovoltaic system usually includes a panel and a power device. The panel may be configured to convert solar energy into electric energy. The power device is configured to perform power conversion on a current from the panel, or may be configured to perform power conversion on a voltage from the panel, to enable output power of the photovoltaic system to match power of an external electric device. For example, the power device includes but is not limited to an inverter, a rectifier, a chopper, and the like. As power of the power device increases, heat generated by components such as a board, an on-board component, and a cable inside a chassis of the power device increases, resulting in an increase in the temperature inside the chassis. This is very detrimental to the components disposed inside the chassis, especially some heat-sensitive components, and a failure risk is significantly increased under the influence of sustained high temperatures.

Currently, the chassis of the power device mainly relies on walls of the chassis for natural heat dissipation to the outside. However, heat dissipation effect of this heat dissipation manner is limited, and effective cooling cannot be implemented inside the chassis. As a result, a service life and reliability of the components inside the chassis cannot be ensured, and then an overall service life of the power device is affected.

To resolve the foregoing problem, in embodiments of this application, the heat dissipation manner of the power device is improved, so that effective heat dissipation inside the power device can be implemented, then a failure risk of the components inside the power device is reduced, and use reliability of the power device is improved. With reference to the accompanying drawings, the following specifically describes the power device provided in embodiments of this application.

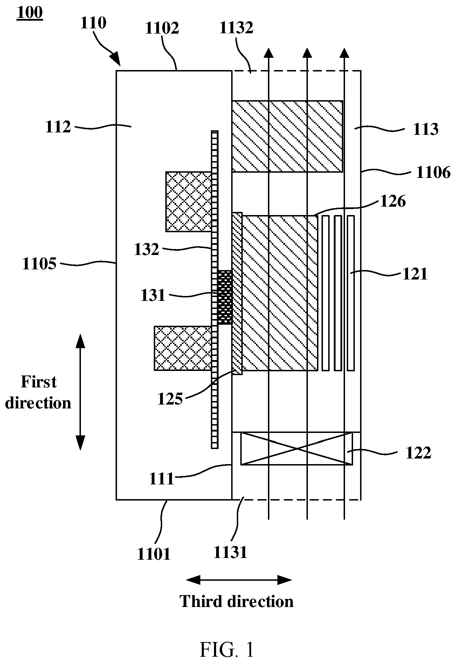

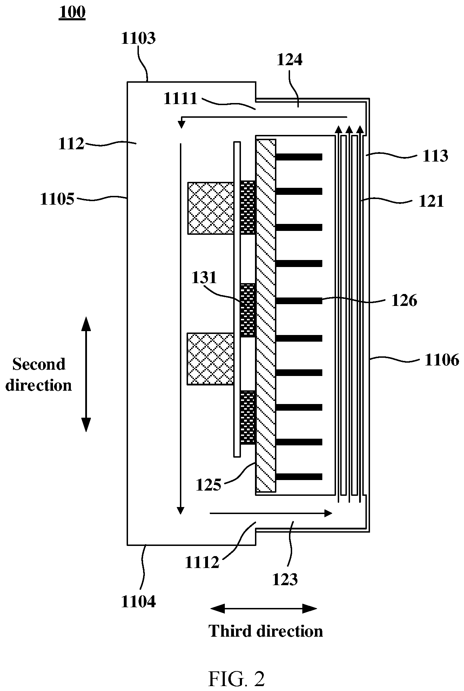

Refer to FIG. 1 and FIG. 2 together. FIG. 1 is a side sectional view of a power device 100 according to an embodiment of this application, and FIG. 2 is a sectional view of the power device 100 shown in FIG. 1 in a top-view state. In this embodiment, the power device 100 may include a housing 110 and a heat dissipation apparatus. A partition board 111 may be disposed in the housing 110. The partition board 111 divides the housing 110 into two cavities: a first cavity 112 and a second cavity 113. The first cavity 112 may be a closed cavity, and the second cavity 113 may be a ventilation cavity. In this way, in the power device 100, components that have a relatively high performance requirement such as water resistance, dust protection, or corrosion resistance may be disposed in the first cavity 112, and components that have no such protection requirement or have a relatively low protection requirement may be disposed in the second cavity 113.

For example, the housing 110 may be approximately of a cuboid structure, and includes a first side wall 1101, a second side wall 1102, a third side wall 1103, a fourth side wall 1104, a fifth side wall 1105, and a sixth side wall 1106. The first side wall 1101 and the second side wall 1102 may be disposed opposite to each other in a first direction. The third side wall 1103 and the fourth side wall 1104 may be disposed opposite to each other in a second direction. The fifth side wall 1105 and the sixth side wall 1106 may be disposed opposite to each other in a third direction. A minimum included angle between the first direction and the second direction may be greater than 0° and less than or equal to 90°. A minimum included angle between the second direction and the third direction may be greater than 0° and less than or equal to 90°. A minimum included angle between the first direction and the third direction may be greater than 0° and less than or equal to 90°.

In an embodiment of this application, the first side wall 1101 is a bottom wall of the power device, the second side wall 1102 is a top wall of the power device, the fifth side wall 1105 is a front side wall of the power device, and the sixth side wall 1106 is a rear side wall of the power device. In this case, the first direction, the second direction, and the third direction may be respectively a height direction, a width direction, and a length direction of the power device 100, and the three directions are perpendicular to each other. In the first direction, two ends of the partition board 111 may be respectively connected to the first side wall 1101 and the second side wall 1102. In this case, the formed first cavity 112 and second cavity 113 are arranged in the third direction. The first side wall 1101 and the second side wall 1102 are respectively provided with an air inlet 1131 and an air outlet 1132 at positions corresponding to the second cavity 113, and the air inlet 1131 and the air outlet 1132 are opposite to each other, to enable the second cavity 113 to implement a ventilation function.

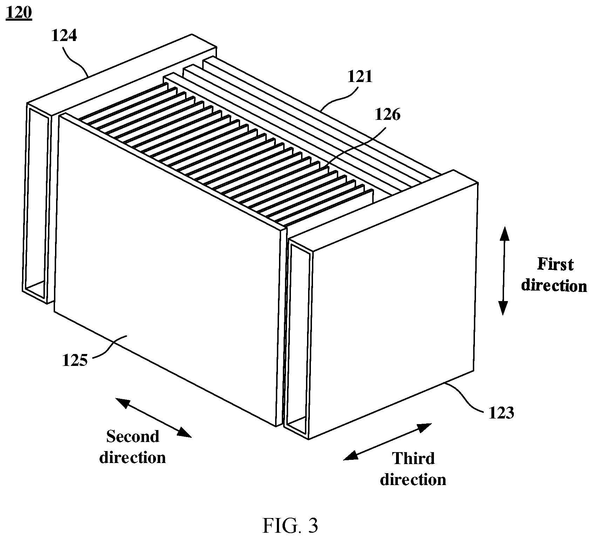

Refer to FIG. 1, FIG. 2, and FIG. 3 together. FIG. 3 is a diagram of a partial structure of the heat dissipation apparatus 120 shown in FIG. 1. The heat dissipation apparatus 120 may include a first fin 121 located in the second cavity, and the first fin 121 is disposed facing the partition board 111. For example, a channel may be provided in the first fin 121, and the channel may run through the first fin 121 in the second direction. In this case, the partition board 111 may be provided with a first opening 1111 and a second opening 1112, and the first opening 1111 and the second opening 1112 separately communicate the first cavity 112 with the second cavity 113. One end of the channel of the first fin 121 may be in communication with the first opening 1111, and the other end of the channel of the first fin 121 may be in communication with the second opening 1112. In this way, an air circulation loop may be formed between an internal part of the first cavity 112 and the channel of the first fin 121, so that air between the first cavity 112 and the channel of the first fin 121 can flow circularly. When high-temperature air in the first cavity 112 enters the channel of the first fin 121, heat exchange may be performed with low-temperature air that flows through a surface of the first fin 121 in the second cavity 113. The air in the second cavity 113 is discharged from the air outlet 1132 after being heated through heat exchange, and the air in the first fin 121 returns to the first cavity 112 after being cooled through heat exchange, thereby implementing heat dissipation inside the first cavity 112.

It may be learned from the foregoing descriptions that, compared with a manner in which cavity walls are used for natural heat dissipation to the outside in a conventional technology, in this embodiment of this application, circular flow and heat dissipation of the air inside the first cavity 112 can be implemented while a design requirement of related protection performance of the power device 100 is met. In this way, heat dissipation effect inside the first cavity 112 can be effectively improved, then a failure risk of the components inside the first cavity 112 can be reduced, and use reliability of the power device 100 can be improved.

In some implementations, there may be a plurality of first fins 121, and an air duct extending in the first direction may be formed between two adjacent first fins 121. That is, a direction of the air duct formed between the two adjacent first fins 121 is consistent with a ventilation direction of the second cavity 113. This helps improve efficiency of heat exchange between the first fins 121 and air entering the second cavity 113, and then can improve heat dissipation effect inside the first cavity 112. For example, the plurality of first fins 121 may be arranged in the third direction. That is, the plurality of first fins 121 may be disposed away from the partition board 111 in sequence.

In addition, the heat dissipation apparatus may further include a first fan 122 (refer to FIG. 1). The first fan 122 is disposed in the second cavity 113, where an air intake side of the first fan 122 is disposed facing the air inlet 1131, and an air exhaust side of the first fan 122 is disposed facing the air outlet 1132, to supply air to one side of the air outlet 1132. In this way, an air circulation rate in the second cavity 113 is improved, and then heat dissipation effect of the heat dissipation apparatus can be improved. For example, the first fan 122 may be located at the end close to the first side wall 1101, or may be located at the end close to the second side wall 1102. This is not limited in this application.

When the channel of the first fin 121 is in communication with the first cavity 112, the heat dissipation apparatus 120 may further include a first guide member 123 and a second guide member 124. Both the first guide member 123 and the second guide member 124 are disposed in the second cavity 113. In addition, one end of the first guide member 123 is in communication with the first opening 1111, the other end may be in communication with one end of each first fin 121, one end of the second guide member 124 is in communication with the second opening 1112, the other end is in communication with the other end of each first fin 121. In this embodiment, the first guide member 123 and the second guide member 124 may further play a role of supporting and fastening the first fin 121 in addition to communicating the channel of the first fin 121 with the internal part of the first cavity 112, thereby improving structural stability of the heat dissipation apparatus 120.

At the end at which the first guide member 123 is in communication with the first opening 1111, the first guide member 123 may be fastened at the first opening 1111 of the partition board 111 by welding, or may be disposed in the first opening 1111 in an assembly manner such as an inserted connection. This is not limited in this application. It should be noted that, when the first guide member 123 is inserted into the first opening 1111, a sealing ring may be further disposed between an outer wall of the first guide member 123 and an inner wall of the first opening 1111, to reduce a risk of air leakage of the first cavity 112 through the first opening 1111. At the end at which the first guide member 123 is in communication with the channel of the first fin 121, the first guide member 123 may be provided with holes that are in a one-to-one correspondence with the plurality of first fins 121, and each first fin 121 may be connected to a corresponding hole by welding or in an inserted connection manner. Similarly, when the first fin 121 is inserted into the hole, a sealing ring may be disposed between an outer wall of the first fin 121 and an inner wall of the hole in an extrusion manner, to reduce a risk of air leakage at the hole. A manner of connecting the second guide member 124 to the second opening 1112 and the first fins 121 may be set with reference to the first guide member 123. Details are not described herein again.

In a specific embodiment, the first opening 1111 and the second opening 1112 may be arranged in the second direction. In this case, the first guide member 123 and the second guide member 124 are disposed opposite to each other in the second direction, so that obstruction to air flow in the second cavity 113 can be reduced, and air entering the second cavity 113 can smoothly flow into the air duct formed between the adjacent first fins 121.

Still refer to FIG. 1, FIG. 2, and FIG. 3. In some embodiments, the heat dissipation apparatus may further include a base board 125 and a second fin 126. The base board 125 may be disposed on the partition board 111. The second fin 126 may be disposed on a side that is of the base board 125 and that is away from the partition board 111, and the second fin 126 extends in a direction away from the base board 125. For example, the second fin 126 may be of a solid thin sheet structure. In an implementation, the components disposed in the first cavity 112 may include a first to-be-heat-dissipated component 131. The first to-be-heat-dissipated component 131 is disposed close to the partition board 111, and may be in heat-conductive contact with the base board 125 located in the second cavity 113, to transfer heat generated when the first to-be-heat-dissipated component 131 works to the base board 125, and further transfer the heat to the second fin 126 via the base board 125. In this way, external air enters the second cavity 113 through the air inlet 1131, and is discharged from the air outlet 1132 after heat exchange with the second fin 126, so that heat of the second fin 126 is taken away. In this way, heat dissipation of the first to-be-heat-dissipated component 131 can be implemented.

In some implementations, the first to-be-heat-dissipated component 131 may be attached to a surface that is of the partition board 111 and that faces the first cavity 112. In this case, the first to-be-heat-dissipated component 131 may be in indirect heat-conductive contact with the base board 125 via the partition board 111.

In some other implementations, the partition board 111 may be provided with a through hole at a position corresponding to the first to-be-heat-dissipated component 131. In this case, the first to-be-heat-dissipated component 131 may extend at least partially into the through hole, to implement direct heat-conductive contact with the base board 125. In this way, efficiency of heat exchange between the first to-be-heat-dissipated component 131 and the heat dissipation apparatus can be improved. This helps improve heat dissipation effect of the first to-be-heat-dissipated component 131.

For example, the first to-be-heat-dissipated component 131 may be a power component. It should be noted that, a reference numeral of the power component below is the same as a reference numeral of the first to-be-heat-dissipated component 131. Because the power component 131 generates a large amount of heat when working, a part of the heat generated by the power component 131 may be dissipated into the first cavity 112, and dissipated to the outside via the first fin 121 that is in communication with the first cavity 112. Another part of the heat may be dissipated to the outside via the second fin 126 in the foregoing heat-conductive contact manner. This can enhance heat dissipation effect of the power component 131, and improve working reliability of the power component 131.

In an implementation, the power device 100 may further include a power board 132 disposed in the first cavity 112. The power board 132 may be approximately parallel to the partition board 111, and the power component 131 may be specifically disposed on a side that is of the power board 132 and that faces the partition board 111. In addition, there may be one or more power components 131. This is not limited in this application. When there are a plurality of power components 131, a through hole may be provided at a position corresponding to each power component 131 on the partition board 111, so that each power component 131 can dissipate heat in a direct heat-conductive contact manner. Certainly, in addition to the power component 131, other electronic components, such as a capacitor, may also be disposed on the power board 132. These electronic components may be disposed on the side that is of the power board 132 and that faces the partition board 111, or may be disposed on a side that is of the power board 132 and that backs the partition board 111. This is not limited in this application.

In this embodiment, a projection of an outer profile of the base board 125 on a surface of the partition board 111 may be located between the first opening 1111 and the second opening 1112. Alternatively, it may be understood that a projection of lines forming outer edges of the base board 125 on a surface of the partition board 111 may be located between the first opening 1111 and the second opening 1112. In this case, the first guide member 123 and the second guide member 124 may be respectively located on two sides of the base board 125 in the second direction. In addition, there may be a plurality of second fins 126, and the plurality of second fins 126 may be arranged in the second direction. In this case, an air duct extending in the first direction may be formed between adjacent second fins 126. That is, an air direction of the air duct formed between the adjacent second fins 126 is consistent with the ventilation direction of the second cavity 113. This helps improve efficiency of heat exchange between the second fins 126 and the air entering the second cavity 113, and then can improve heat dissipation effect of the first to-be-heat-dissipated component 131.

Still refer to FIG. 1, FIG. 2, and FIG. 3. In a specific embodiment, the first fins 121 may be disposed on a side that is of a free end of each of the plurality of second fins 126 and that is away from the base board 125. The free end of the second fin 126 may be understood as an end that is of the second fin 126 and that is away from the base board. For example, projections of the plurality of first fins 121 on a surface of the base board 125 may overlap with projections of the plurality of second fins 126 on the surface of the base board 125. This design is used, so that structural compactness of the heat dissipation apparatus 120 can be improved, and space occupied by the heat dissipation apparatus 120 in the power device 100 can be reduced. In addition, in the ventilation direction of the second cavity 113, the first fins 121 and the second fins 126 are approximately at a same height. Therefore, low-temperature air entering the second cavity 113 from the air inlet 1131 can approximately synchronously pass through the first fins 121 and the second fins 126, so that temperatures of the two groups of fins cannot affect each other. This helps improve the heat dissipation effect of the heat dissipation apparatus.

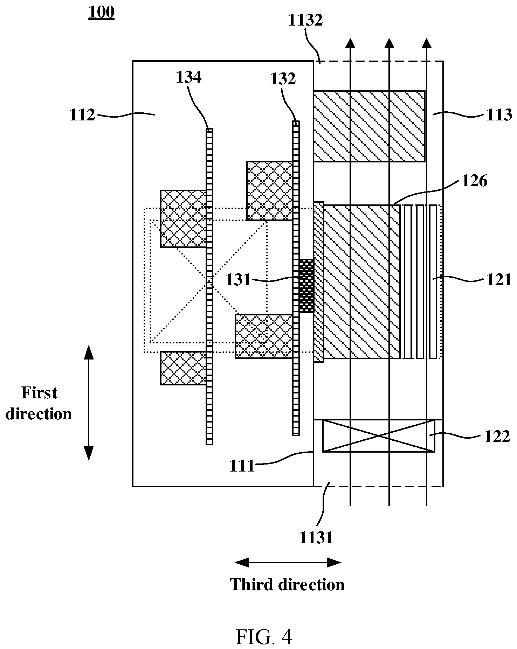

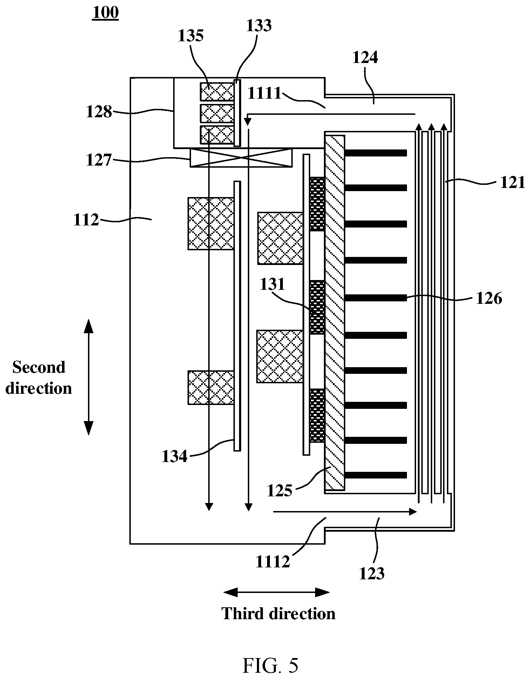

Refer to FIG. 4 and FIG. 5 together. FIG. 4 is a side sectional view of another power device 100 according to an embodiment of this application, and FIG. 5 is a sectional view of the power device 100 shown in FIG. 4 in a top-view state. In this embodiment, a heat dissipation apparatus may further include a second fan 127. The second fan 127 may be disposed in a first cavity 112, and the second fan 127 is disposed close to a first opening 1111. In this case, components disposed in the first cavity 112 may further include a second to-be-heat-dissipated component 133 and a third to-be-heat-dissipated component 134, where the second to-be-heat-dissipated component 133 may be disposed between the first opening 1111 and an air intake side of the second fan 127, and the third to-be-heat-dissipated component 134 may be disposed between an air exhaust side of the second fan 127 and a second opening 1112. In an implementation, the second to-be-heat-dissipated component 133 may be located at one end of the third to-be-heat-dissipated component 134 in a second direction, and the third to-be-heat-dissipated component 134 may be located on a side that is of the first to-be-heat-dissipated component 131 and that is away from a partition board 111.

When air cooled through heat exchange in a first fin 121 enters the first cavity 112 from the first opening 1111, the low-temperature air may first pass through the second to-be-heat-dissipated component 133, and then be blown to the third to-be-heat-dissipated component 134 by the second fan 127 after heat exchange with the second to-be-heat-dissipated component 133, to further perform heat exchange with the third to-be-heat-dissipated component 134, and then flow to the first fin 121 from the second opening 1112, to complete a cycle. In this setting, a position of a to-be-heat-dissipated component in the first cavity 112 may be arranged based on a heat dissipation priority or a heat dissipation amount of the to-be-heat-dissipated component in the first cavity 112. For example, a component having a relatively high heat dissipation priority may be placed in an up stream of a component having a relatively low heat dissipation priority, or a component having a relatively low heat dissipation amount may be placed in an up stream of a component having a relatively high heat dissipation amount, to ensure heat dissipation effect of each to-be-heat-dissipated component.

For example, the second to-be-heat-dissipated component 133 may be an electrolytic capacitor board, and the third to-be-heat-dissipated component 134 may be an output board. It should be noted that, a reference numeral of the electrolytic capacitor board below is the same as a reference numeral of the second to-be-heat-dissipated component 133, and a reference numeral of the output board is the same as a reference numeral of the third to-be-heat-dissipated component 134. One or more electrolytic capacitors 135 may be disposed on the electrolytic capacitor board 133, and components such as a relay, a common-mode inductor, and a capacitor may be disposed on the output board 134. The electrolytic capacitor 135 generates a relatively small amount of heat. Therefore, the electrolytic capacitor 135 is disposed in an up stream of a heat dissipation loop. The low-temperature air that enters the first cavity 112 from the first opening 1111 may still be at a relatively low temperature after heat exchange with the electrolytic capacitor 135, so that good heat dissipation effect can still be achieved for another downstream component. In addition, the electrolytic capacitor 135 is a heat-sensitive component. Therefore, placement of the electrolytic capacitor 135 at the first opening 1111 may further reduce a risk of failure of the electrolytic capacitor 135 due to a high temperature, and then overall use reliability of the power device 100 can be improved.

In some implementations, the heat dissipation apparatus may further include a third guide member 128, and the third guide member 128 is disposed in the first cavity 112. In addition, one end of the third guide member 128 may be in communication with the first opening 1111, and the third guide member 128 is provided with a first air vent (not shown in the figure) at a position facing the third to-be-heat-dissipated component 134. In this case, the second to-be-heat-dissipated component 133 may be disposed in the third guide member 128, the second fan 127 may be disposed at the first air vent of the third guide member 128, and the air intake side of the second fan 127 is opposite to the first air vent, to blow air in the third guide member 128 to the third to-be-heat-dissipated component 134. The third guide member 128 is disposed, so that the second to-be-heat-dissipated component 133 may be limited to relatively sealed space, and a risk that air on the air exhaust side of the second fan 127 flows back to a place near the second to-be-heat-dissipated component 133 is reduced. This helps further improve heat dissipation effect of the second to-be-heat-dissipated component 133.

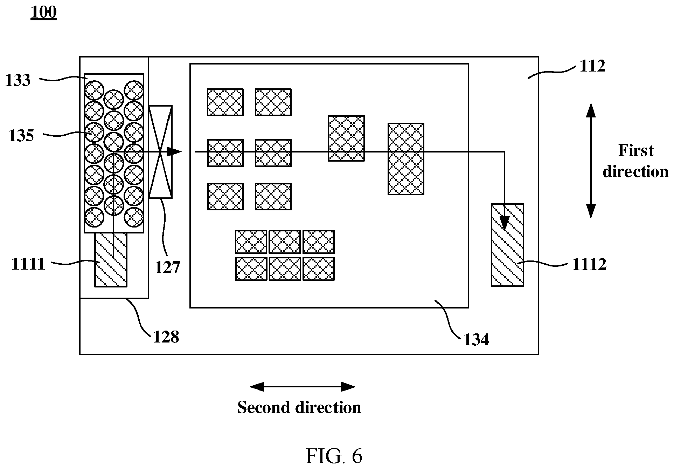

FIG. 6 is a sectional view of the first cavity 112 of the power device 100 shown in FIG. 4 in a direction perpendicular to a third direction. Refer to FIG. 4 to FIG. 6 together. In this embodiment, the second to-be-heat-dissipated component 133 may be disposed approximately parallel to the third to-be-heat-dissipated component 134. When the second to-be-heat-dissipated component 133 is an electrolytic capacitor board, and the third to-be-heat-dissipated component 134 is an output board, the electrolytic capacitor board 133, the output board 134, and the power board 132 may be parallel to each other, and the output board 134 is located on a side that is of the power board 132 and that is away from the partition board 111.

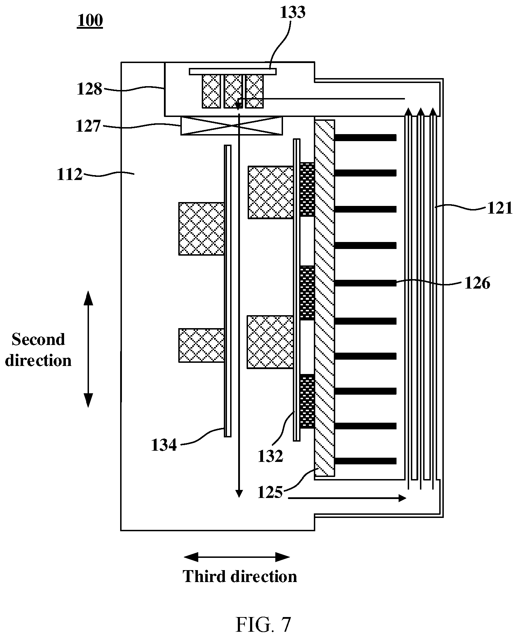

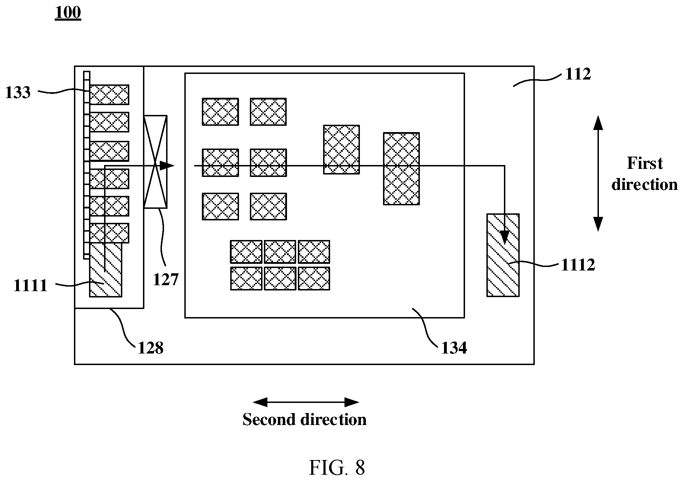

Refer to FIG. 7 and FIG. 8 together. FIG. 7 is a sectional view of another power device 100 in a top-view state according to an embodiment of this application, and FIG. 8 is a sectional view of a first cavity 112 of the power device 100 shown in FIG. 7 in a direction perpendicular to a third direction. In this embodiment, a heat dissipation apparatus of the power device 100 may be disposed with reference to embodiments shown in FIG. 4 to FIG. 6. A difference lies in that, in this embodiment, a second to-be-heat-dissipated component 133 and a third to-be-heat-dissipated component 134 may be approximately perpendicular to each other. When the second to-be-heat-dissipated component 133 is an electrolytic capacitor board, and the third to-be-heat-dissipated component 134 is an output board, the electrolytic capacitor board 133 may be disposed parallel to a first direction, and the output board 134 may still be located on a side that is of a power board 132 and that is away from a partition board and be parallel to the power board 132.

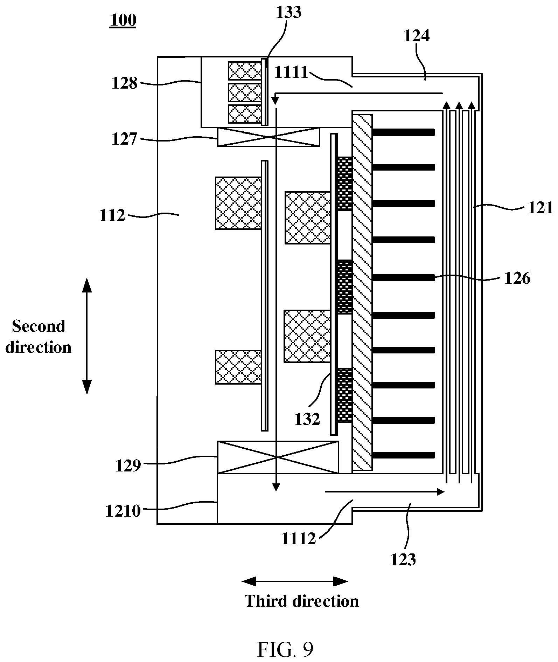

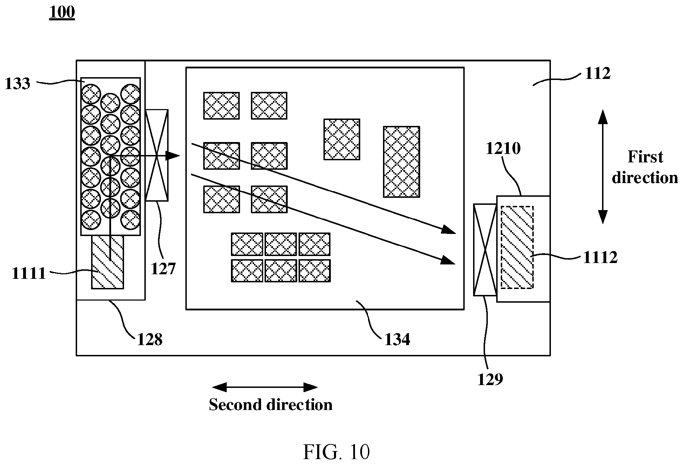

Refer to FIG. 9 and FIG. 10 together. FIG. 9 is a sectional view of another power device 100 in a top-view state according to an embodiment of this application, and FIG. 10 is a sectional view of a first cavity 112 of the power device 100 shown in FIG. 9 in a direction perpendicular to a third direction. In this embodiment, a heat dissipation apparatus may further include a third fan 129 and a fourth guide member 1210. Both the third fan 129 and the fourth guide member 1210 may be disposed in the first cavity 112, and the third fan 129 and the fourth guide member 1210 are disposed close to a second opening 1112. One end of the fourth guide member 1210 may be in communication with the second opening 1112, and the fourth guide member 1210 may be provided with a second air vent (not shown in the figure) at a position facing a third to-be-heat-dissipated component 134. The third fan 129 may be disposed at the second air vent, an air intake side of the third fan 129 is disposed facing the third to-be-heat-dissipated component 134, and an air exhaust side of the third fan 129 is opposite to the second air vent, so that high-temperature air obtained after heat exchange with the third to-be-heat-dissipated component 134 is sent into the fourth guide member 1210, and further flows into a channel of a first fin 121 via the fourth guide member 1210 for cooling through heat exchange.

In a specific embodiment, the third fan 129 and a second fan 127 may be respectively arranged on two sides of the first cavity 112 in a second direction. In this case, the fourth guide member 1210 and a third guide member 128 are also disposed approximately opposite to each other in the second direction. In the solution of this embodiment, a flow rate of air in the first cavity 112 can be increased, to achieve an objective of improving heat dissipation efficiency of each to-be-heat-dissipated component in the first cavity 112. In addition, the third fan 129 and the fourth guide member 1210 are disposed, to further reduce the risk that air flows back to a place near a second to-be-heat-dissipated component 133. This helps improve use reliability of the second to-be-heat-dissipated component 133.

In addition, in this embodiment, the second to-be-heat-dissipated component 133 may be disposed approximately parallel to the third to-be-heat-dissipated component 134. When the second to-be-heat-dissipated component 133 is an electrolytic capacitor board, and the third to-be-heat-dissipated component 134 is an output board, the electrolytic capacitor board 133, the output board 134, and a power board 132 may be parallel to each other, and the output board 134 is located on a side that is of the power board 132 and that is away from a partition board.

Certainly, in some other implementations, reference may also be made to the manner shown in FIG. 7 and FIG. 8, so that the second to-be-heat-dissipated component and the third to-be-heat-dissipated component are approximately perpendicular to each other. When the second to-be-heat-dissipated component is an electrolytic capacitor board and the third to-be-heat-dissipated component is an output board, the electrolytic capacitor board may be disposed parallel to a first direction, and the output board may still be located on the side that is of the power board and that is away from the partition board and be parallel to the power board.

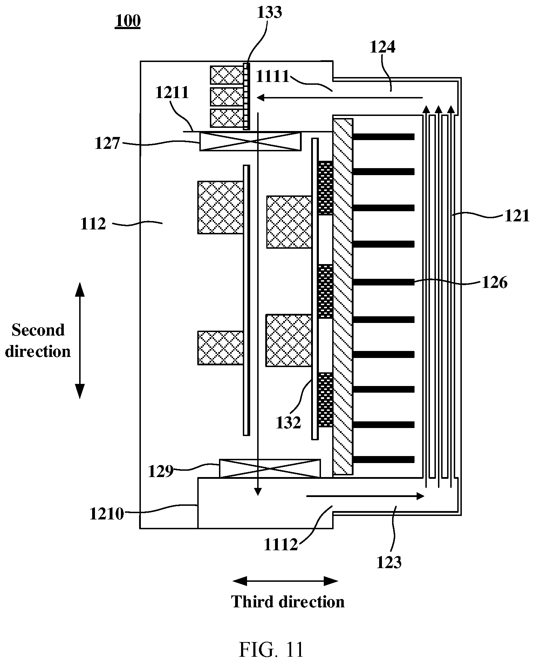

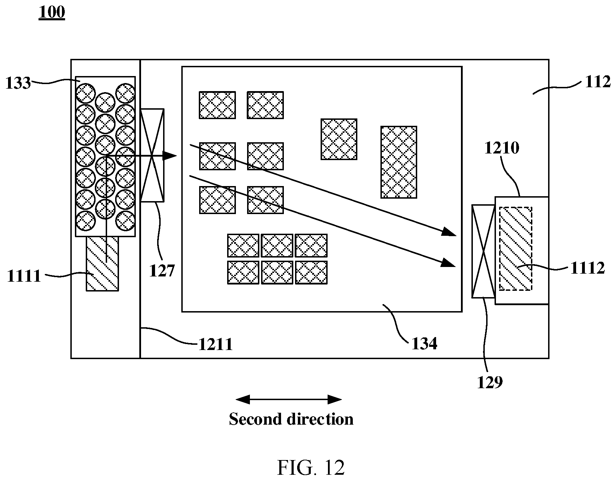

Refer to FIG. 11 and FIG. 12 together. FIG. 11 is a sectional view of another power device 100 in a top-view state according to an embodiment of this application, and FIG. 12 is a sectional view of a first cavity 112 of the power device 100 shown in FIG. 11 in a direction perpendicular to a third direction. In comparison with the foregoing embodiment shown in FIG. 9 and FIG. 10, a third guide member is omitted in this embodiment. In this case, to facilitate mounting of a second fan 127, a mounting board 1211 may be further disposed in the first cavity 112. The mounting board 1211 is disposed between a second to-be-heat-dissipated component 133 and a third to-be-heat-dissipated component 134, and a third air vent (not shown in the figure) may be provided on the mounting board 1211. In this case, the second to-be-heat-dissipated component 133 may be isolated in space between a side wall of a housing and the mounting board 1211, the second fan 127 is disposed at the third air vent of the mounting board 1211, and an air intake side of the second fan 127 is opposite to the third air vent, to blow air between the side wall and the mounting board 1211 to the third to-be-heat-dissipated component 134. This solution can also reduce a risk that air on an air exhaust side of the second fan 127 flows back to a place near the second to-be-heat-dissipated component 133, thereby helping improve heat dissipation effect of the second to-be-heat-dissipated component 133.

Similarly, in this embodiment, the second to-be-heat-dissipated component 133 may be disposed approximately parallel to the third to-be-heat-dissipated component 134. When the second to-be-heat-dissipated component 133 is an electrolytic capacitor board, and the third to-be-heat-dissipated component 134 is an output board, the electrolytic capacitor board 133, the output board 134, and a power board 132 may be parallel to each other, and the output board 134 is located on a side that is of the power board 132 and that is away from a partition board.

Certainly, in some other implementations, reference may also be made to the manner shown in FIG. 7 and FIG. 8, so that the second to-be-heat-dissipated component and the third to-be-heat-dissipated component are approximately perpendicular to each other. When the second to-be-heat-dissipated component is an electrolytic capacitor board and the third to-be-heat-dissipated component is an output board, the electrolytic capacitor board may be disposed parallel to a first direction, and the output board may still be located on the side that is of the power board and that is away from the partition board and be parallel to the power board.

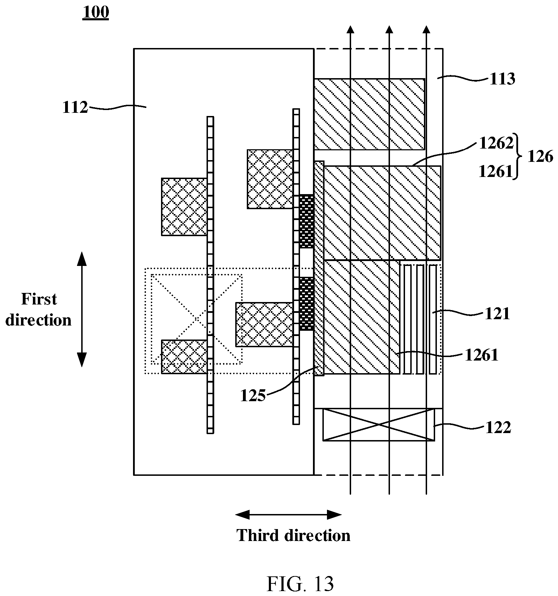

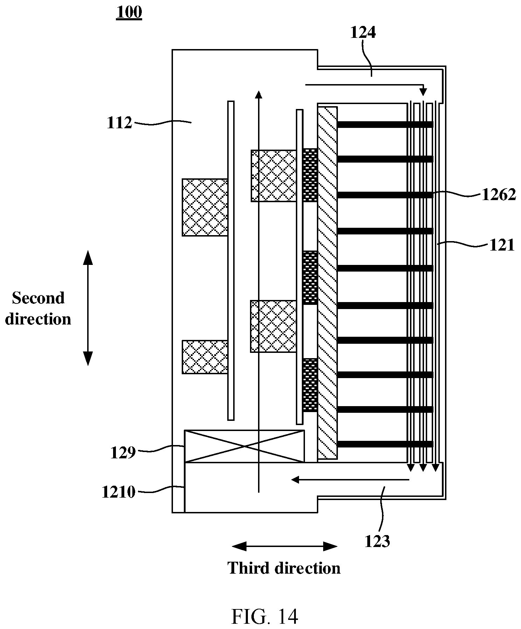

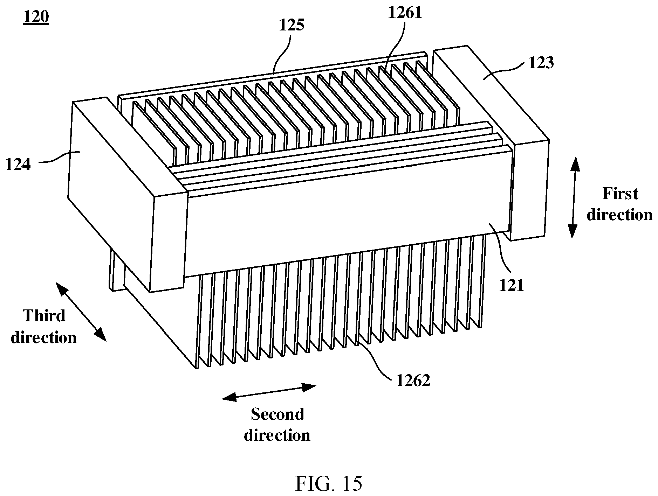

Refer to FIG. 13, FIG. 14, and FIG. 15 together. FIG. 13 is a side sectional view of another power device 100 according to an embodiment of this application. FIG. 14 is a sectional view of the power device 100 shown in FIG. 13 in a top-view state. FIG. 15 is a diagram of a partial structure of a heat dissipation apparatus 120 shown in FIG. 14. In this embodiment, the heat dissipation apparatus 120 may also include structures such as first fins 121, a base board 125, second fins 126, a first guide member 123, a second guide member 124, and a first fan 122. Different from the foregoing embodiments, the plurality of second fins 126 in this embodiment may be designed as two portions of different heights: a first portion and a second portion, and the two portions of the second fins 126 are arranged in a first direction. A height of second fins 1261 in the first portion is less than a height of second fins 1262 in the second portion. It should be noted that a height direction of the second fins 126 herein may be understood as a direction in which the second fins 126 are away from the base board 125, namely, the third direction defined above. In this case, the first fins 121 may be disposed on a side that is of a free end of each second fin 1261 in the first portion and that is away from the base board 125. That is, projections of the plurality of first fins 121 on a surface of the base board 125 may overlap with projections of the plurality of second fins 1261 in the first portion on the surface of the base board 125. This design can also achieve effect of improving structural compactness of the heat dissipation apparatus.

In addition, it should be noted that, in this embodiment, a third guide member, the fourth guide member 1210, a second fan, and a third fan 129 may be selectively disposed based on a heat dissipation requirement in a first cavity. FIG. 14 only schematically shows a case in which the fourth guide member 1210 and the third fan 129 are disposed in the first cavity 112.

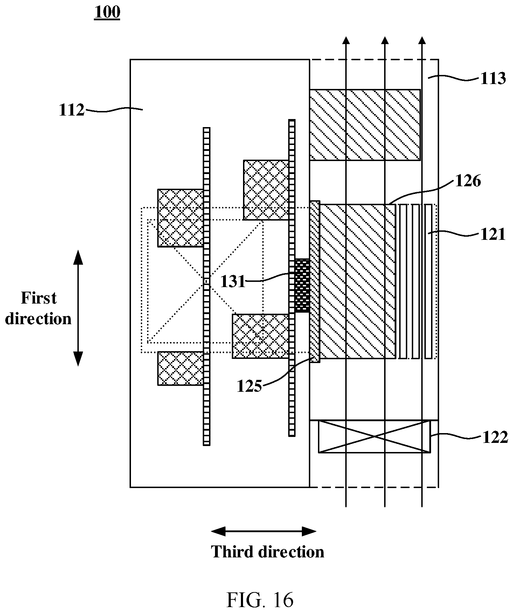

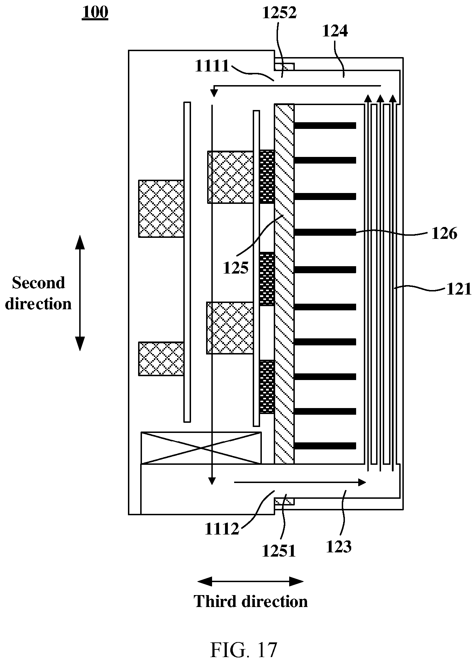

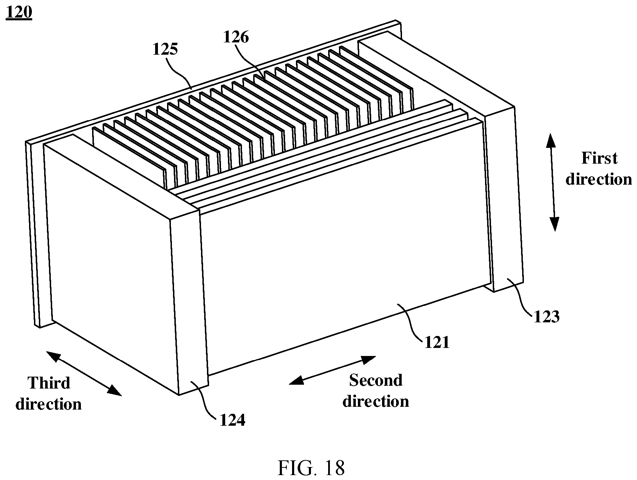

Refer to FIG. 16, FIG. 17, and FIG. 18 together. FIG. 16 is a side sectional view of another power device 100 according to an embodiment of this application. FIG. 17 is a sectional view of the power device 100 shown in FIG. 16 in a top-view state. FIG. 18 is a diagram of a partial structure of a heat dissipation apparatus 120 shown in FIG. 16. In this embodiment, the heat dissipation apparatus 120 may also include structures such as first fins 121, a base board 125, second fins 126, a first guide member 123, a second guide member 124, and a first fan 122. Different from the foregoing embodiments, in this embodiment, a region enclosed by a projection of an outer profile of the base board 125 on a surface of a partition board may cover a first opening 1111 and a second opening 1112. In other words, a projection of lines forming outer edges of the base board 125 on the surface of the partition board may cover the first opening 1111 and the second opening 1112. In this case, to communicate the first guide member 123 and the second guide member 124 with a first cavity 112, the base board 125 is provided with a first avoidance hole 1251 and a second avoidance hole 1252 respectively at positions corresponding to the first opening 1111 and the second opening 1112. For example, an end of the first guide member 123 may pass through the first avoidance hole 1251 to communicate with the first opening 1111, and an end of the second guide member 124 may pass through the second avoidance hole 1252 to communicate with the second opening 1112. This design can increase an area of the base board 125, thereby helping improve heat dissipation effect of a first to-be-heat-dissipated component 131.

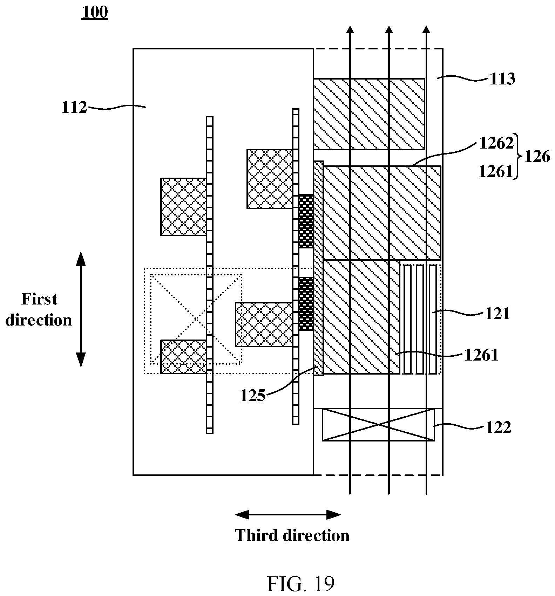

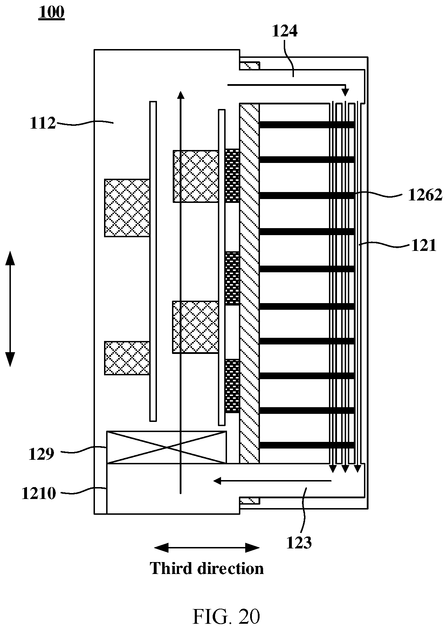

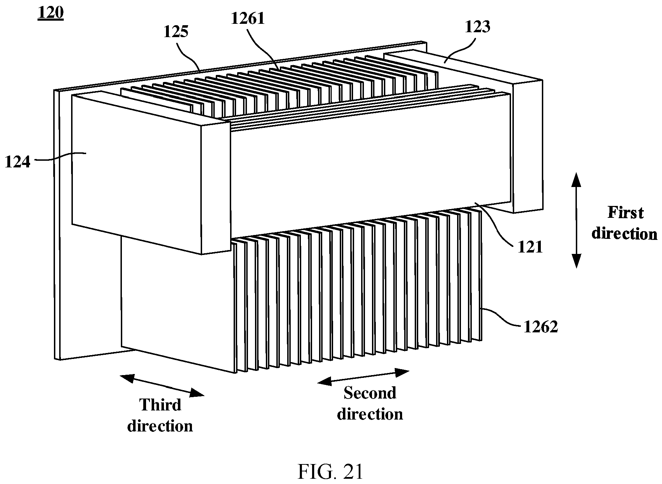

Refer to FIG. 19, FIG. 20, and FIG. 21 together. FIG. 19 is a side sectional view of another power device 100 according to an embodiment of this application. FIG. 20 is a sectional view of the power device 100 shown in FIG. 19 in a top-view state. FIG. 21 is a diagram of a partial structure of a heat dissipation apparatus 120 shown in FIG. 19. In this embodiment, first fins 121 and second fins 126 may use an arrangement manner in the embodiment shown in FIG. 12 and FIG. 13. Different from the embodiment shown in FIG. 12 and FIG. 13, in this embodiment, a region enclosed by a projection of an outer profile of a base board 125 on a surface of a partition board may also cover a first opening 1111 and a second opening 1112, and the base board is provided with a first avoidance hole 1251 and a second avoidance hole 1252 respectively at positions opposite to the first opening 1111 and the second opening 1112, to communicate a first guide member 123 and a second guide member 124 with a first cavity 112.

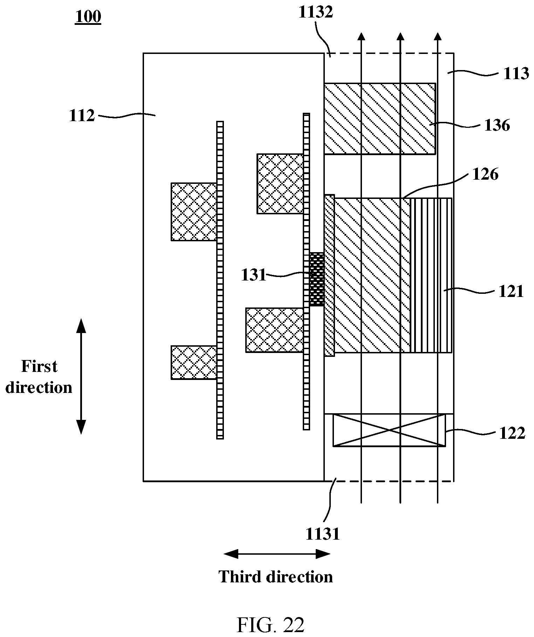

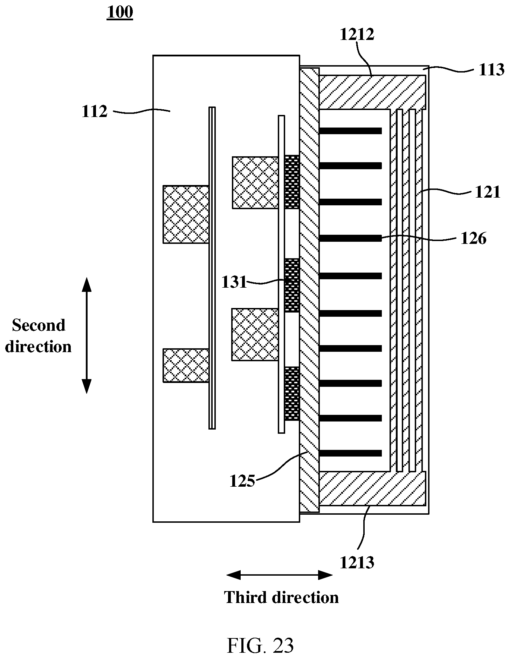

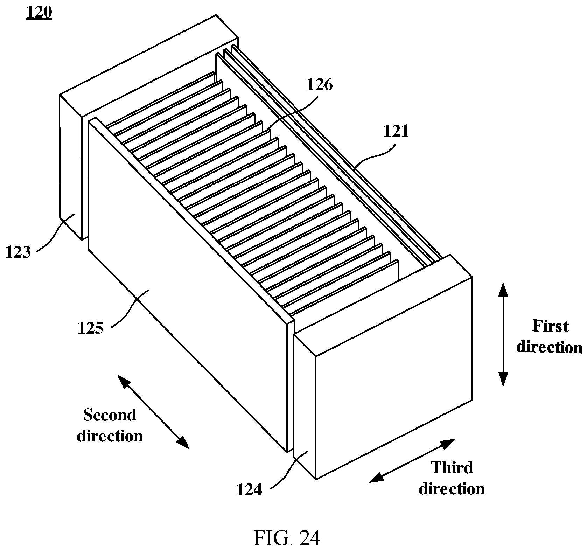

Refer to FIG. 22 and FIG. 23 together. FIG. 22 is a side sectional view of another power device 100 according to an embodiment of this application. FIG. 23 is a sectional view of the power device 100 shown in FIG. 22 in a top-view state. FIG. 24 is a diagram of a partial structure of a heat dissipation apparatus 120 shown in FIG. 22. In this embodiment, the heat dissipation apparatus may include structures such as first fins 121, a base board 125, second fins 126, and a first fan 122. For a position relationship of each component, refer to the descriptions in the foregoing embodiments. Details are not described herein again. Different from the foregoing embodiments, in this embodiment, both the first fins 121 and the second fins 126 may be of solid thin sheet structure, and the first fins 121 are no longer in communication with a first cavity 112. In this case, the heat dissipation apparatus further includes a first support member 1212 and a second support member 1213. The first support member 1212 and the second support member 1213 are disposed in a second cavity 113 opposite to each other in a second direction. One end of the first support member 1212 and one end of the second support member 1213 are separately fixedly connected to the base board 125, and the other end of the first support member 1212 and the other end of the second support member 1213 are respectively fixedly connected to two ends of the first fins 121, to support the first fins 121 on a side that is of the second fins 126 and that is away from the base board 125.

In this embodiment, after heat generated when the first to-be-heat-dissipated component 131 works is transferred to the base board 125, a part of the heat may be directly transferred to the second fins 126 via the base board 125, and another part of the heat may be transferred to the first support member 1212 and the second support member 1213 via the base board 125, and further transferred to the first fins 121 via the first support member 1212 and the second support member 1213. After entering the second cavity 113 through an air inlet 1131, external air performs heat exchange with both the first fins 121 and the second fins 126, and finally is discharged from an air outlet 1132, to take away heat of the first fins 121 and the second fins 126. It may be learned that both the first fins 121 and the second fins 126 in this embodiment are configured to dissipate heat for a first to-be-heat-dissipated component 131, so that heat dissipation effect of the first to-be-heat-dissipated component 131 can be improved.

In addition, it should be noted that, in the foregoing embodiments, a fourth to-be-heat-dissipated component 136 may be further disposed in the second cavity 113 of the power device 100. The fourth to-be-heat-dissipated component 136 may be disposed on a side that is of the first fins 121 and that faces the air outlet 1132. That is, the fourth to-be-heat-dissipated component 136 is located in a downstream of a ventilation path of the second cavity 113. In this way, low-temperature air entering the second cavity 113 may preferably perform heat exchange with the first fins 121 and the second fins 126, so that heat dissipation effect of each component in the first cavity 112 is ensured. Because a protection requirement of the fourth to-be-heat-dissipated component 136 is relatively low, specific heat dissipation effect may still be achieved when the fourth to-be-heat-dissipated component 136 is disposed in a downstream of a heat dissipation path, and a normal operation of the fourth to-be-heat-dissipated component 136 is ensured. For example, the fourth to-be-heat-dissipated component 136 may be a magnetic component such as an inductor.

It should be understood that, in embodiments of this application, a component disposed in the first cavity is not limited to the first to-be-heat-dissipated component, the second to-be-heat-dissipated component, and the third to-be-heat-dissipated component that are mentioned above. Similarly, a component disposed in the second cavity is not limited to the fourth to-be-heat-dissipated component mentioned above. In actual application, a matching component may be disposed based on a specific type of a power device. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power device (100), comprising a housing (110) and a heat dissipation apparatus (120), wherein
a partition board (111) is disposed in the housing (110), the partition board (111) divides the housing (110) into a first cavity (112) and a second cavity (113), and the partition board (111) is provided with a first opening (1111) and a second opening (1112) that communicate the first cavity (112) with the second cavity (113); a to-be-heat-dissipated component is disposed in the first cavity (112), the second cavity (113) is provided with an air inlet (1131) and an air outlet (1132), and the air inlet (1131) and the air outlet (1132) are provided opposite to each other in a first direction;
the heat dissipation apparatus (120) comprises a first fin (121) disposed in the second cavity (113), a surface of the first fin (121) faces the partition board (111), a channel is provided in the first fin (121), and the channel runs through the first fin (121) in a second direction; two ends of the channel are respectively in communication with the first opening (1111) and the second opening (1112); and
a minimum included angle between the second direction and the first direction is greater than 0° and less than or equal to 90°.

2. The power device (100) according to claim 1, wherein there are a plurality of first fins (121), and an air duct extending in the first direction is formed between the adjacent first fins (121).

3. The power device (100) according to claim 1 or 2, wherein the heat dissipation apparatus (120) further comprises a first guide member (123) and a second guide member (124) that are disposed in the second cavity (113), one end of the first guide member (123) is in communication with the first opening (1111), the other end is in communication with one end of the channel (121), one end of the second guide member (124) is in communication with the second opening (1112), and the other end is in communication with the other end of the channel.

4. The power device (100) according to any one of claims 1 to 3, wherein the to-be-heat-dissipated component (131) in the first cavity (112) comprises a first to-be-heat-dissipated component (131), and the first to-be-heat-dissipated component (131) is disposed close to the partition board (111); and
the heat dissipation apparatus (120) further comprises a plurality of second fins (126) and a base board (125) that are disposed in the second housing (113), wherein the base board (125) is disposed on the partition board, the base board (125) is in heat-conductive contact with the first to-be-heat-dissipated device (131), the second fins (126) are disposed on a side that is of the base board (125) and that is away from the partition board (111) and extend in a direction away from the partition board (111), and an air duct extending in the first direction is formed between the adjacent second fins (126).

5. The power device (100) according to claim 4, wherein the first fins (121) are disposed on a side that is of a free end of each of the plurality of second fins (126) and that is away from the base board (125).

6. The power device (100) according to claim 4, wherein the plurality of second fins (126) are divided into a first portion and a second portion, and a height of the second fins (1261) in the first portion is less than a height of the second fins (1262) in the second portion in a direction away from the base board (125); and
the first fins are disposed on a side that is of a free end of each second fin in the first portion and that is away from the base board.

7. The power device (100) according to any one of claims 4 to 6, wherein a projection of an outer profile of the base board (125) on a surface of the partition board (111) is located between the first opening (1111) and the second opening (1112); or
a region enclosed by a projection of an outer profile of the base board (125) on a surface of the partition board (111) covers the first opening (1111) and the second opening (1112), and the base board is provided with a first avoidance hole and a second avoidance hole respectively at positions corresponding to the first opening (1111) and the second opening (1112).

8. The power device (100) according to any one of claims 4 to 7, wherein the partition board (111) is provided with a hole at a position corresponding to the first to-be-heat-dissipated component (131), and the first to-be-heat-dissipated component (131) extends into the hole and is in heat-conductive contact with the base board (125).

9. The power device (100) according to any one of claims 1 to 8, wherein the heat dissipation apparatus (120) further comprises a first fan (122) disposed in the second cavity (113), an air intake side of the first fan (122) is disposed facing the air inlet (1131), and an air exhaust side of the first fan (122) is disposed facing the air outlet (1132).

10. The power device (100) according to any one of claims 1 to 9, wherein the to-be-heat-dissipated component in the first cavity (112) comprises a second to-be-heat-dissipated component (133) and a third to-be-heat-dissipated component (134); and
the heat dissipation apparatus (120) further comprises a second fan (127) disposed in the first cavity (112), the second to-be-heat-dissipated component (133) is disposed between the first opening (1111) and an air intake side of the second fan (127), the third to-be-heat-dissipated component (134) is disposed between an air exhaust side of the second fan (127) and the second opening (1112), and the third to-be-heat-dissipated component (133) is located on a side that is of the first to-be-heat-dissipated component (131) and that is away from the partition board (111).

11. The power device (100) according to claim 10, wherein the heat dissipation apparatus (120) further comprises a third guide member (128) disposed in the first cavity (112), the third guide member (128) is in communication with the first opening (1111), and the third guide member (128) is provided with a first air vent at a position facing the third to-be-heat-dissipated component (134); and
the second to-be-heat-dissipated component (133) is disposed in the third guide member (128), the second fan (127) is disposed at the first air vent, and the air intake side of the second fan (127) is disposed opposite to the first air vent.

12. The power device (100) according to claim 10 or 11, wherein the heat dissipation apparatus (120) further comprises a third fan (129) and a fourth guide member (1210) that are disposed in the first cavity (112), the fourth guide member (1210) is in communication with the second opening (1112), and the fourth guide member (1210) is provided with a second air vent at a position facing the third to-be-heat-dissipated component (134); and
the third fan (129) is disposed at the second air vent, an air intake side of the third fan (129) is disposed facing the third to-be-heat-dissipated component (134), and an air exhaust side of the second fan (129) is disposed opposite to the second air vent.

13. The power device (100) according to any one of claims 10 to 12, wherein the second to-be-heat-dissipated component (133) is an electrolytic capacitor board; and/or the third to-be-heat-dissipated component (134) is an output board.

14. The power device (100) according to any one of claims 1 to 13, wherein a fourth to-be-heat-dissipated component (136) is disposed in the second cavity (113), and the fourth to-be-heat-dissipated component (136) is disposed on a side that is of the first fin (121) and that faces the air outlet (1132).

15. A photovoltaic system, comprising a panel and the power device (100) according to any one of claims 1 to 14, wherein the panel is configured to convert solar energy into electric energy, and the power device is configured to convert a current and/or a voltage from the panel.
